# EUROPEAN PATENT SPECIFICATION

(11) **EP 4 139 900 B1**
(45) Date of publication and mention of the grant of the patent: **30.09.2026**
(21) Application number: 20725432.7
(22) Date of filing: 24.04.2020
(51) Int. Cl.: G06T 13/20

(54) **A COMPUTER IMPLEMENTED METHOD OF SIMULATING A 3D OBJECT**
COMPUTERIMPLEMENTIERTES VERFAHREN ZUR SIMULATION EINES 3D-OBJEKTS
PROCÉDÉ MIS EN OEUVRE PAR ORDINATEUR DE SIMULATION D'UN OBJET 3D

(43) Date of publication of application: 01.03.2023
(73) Proprietor: Robotify Labs Limited, Dublin 9 (IE)
(72) Inventor: MURPHY, Andrew, Dublin D6W E977 (IE); DALTON, Adam, Dublin D13 F2W5 (IE); DARCY, Evan, Dublin K67 AP66 (IE)
(74) Representative: O'Connor, Michael Donal
(86) International application number: PCT/EP2020/061530
(87) International publication number: WO 2021/213680

(56) References cited:
- CN-A- 108 543 307
- US-A1- 2011 283 086
- US-A1- 2020 004 759
- YOGYA RESA ET AL: "Comparison of Physics Frameworks for WebGL-Based Game Engine", EPJ WEB OF CONFERENCES - POWDERS & GRAINS 2021 - 9TH INTERNATIONAL CONFERENCE ON MICROMECHANICS ON GRANULAR MEDIA, vol. 68, 28 March 2014 (2014-03-28), Les Ulis (France), pages 1 - 5, XP093314572, ISSN: 2100-014X, Retrieved from the Internet <URL:https://www.epj-conferences.org/articles/epjconf/pdf/2014/05/epjconf_icas2013_00035.pdf> DOI: 10.1051/epjconf/20146800035
- BLUE MAGNIFICENT: "Intro to JavaScript 3D Physics using Ammo.js and Three.js", 3 April 2019 (2019-04-03), pages 1 - 32, XP093314587, Retrieved from the Internet <URL:https://medium.com/@bluemagnificent/intro-to-javascript-3d-physics-using-ammo-js-and-three-js-dd48df81f591>
- BLUE MAGNIFICENT: "Moving Objects In JavaScript 3D Physics using Ammo.js and Three.js", 28 December 2019 (2019-12-28), pages 1 - 28, XP093314588, Retrieved from the Internet <URL:https://medium.com/@bluemagnificent/moving-objects-in-javascript-3d-physics-using-ammo-js-and-three-js-6e39eff6d9e5>
- ANONYMOUS: "Paid work converting PhysX to WebAssembly . Issue #288 . kripken/ammo.js", 7 January 2020 (2020-01-07), pages 1 - 4, XP093314575, Retrieved from the Internet <URL:https://github.com/kripken/ammo.js/issues/288>
- ANONYMOUS: "Physics engine", 13 February 2020 (2020-02-13), Wikipedia.org, pages 1 - 6, XP055763109, Retrieved from the Internet <URL:https://en.wikipedia.org/w/index.php?title=Physics_engine&oldid=940594218> [retrieved on 20210108]
- ANONYMOUS: "Three.js", 15 April 2020 (2020-04-15), Wikipedia.org, pages 1 - 5, XP055763110, Retrieved from the Internet <URL:https://en.wikipedia.org/w/index.php?title=Three.js&oldid=951105912> [retrieved on 20210108]

## Description

### Technical Field:

This invention relates to a computer implemented method of simulating a three-dimensional (3D) object for display in a browser on a client's device. This invention further relates to a computer program product, and an in-browser robotics 3D object simulator.

### Background Art:

Simulation of three-dimensional objects, and in particular simulation of robotics, is a multi-billion-dollar business with substantial potential. It is highly advantageous to provide customers with the ability to render their robotics in a web browser where they can create, view and share their simulations. In this way, the simulations can be used for a wide array of different purposes, from training to testing, evaluation to education.

There are however a number of problems with the existing offerings. Heretofore, the existing offerings have been quite limited. Generally speaking, due to the computational burden placed on the processor, the simulations for all but the most basic robots and three-dimensional objects are necessarily at a low frame rate when being executed on a customer's machine. This low frame rate tends to lead to a jittery, stop-start simulation that is difficult to properly evaluate and appreciate.

Secondly, heretofore, the simulations for delivery though a browser have been limited by the use of relatively old physics engines, such as, but not limited to, Bullet v.2.82 (released 2013). Although useful for many projects, Bullet 2.82 is quite limited in its application compared with newer physics engines and does not support functionality typically supported by more modern non-web-based physics engines. Furthermore, it is generally accepted that development with in-browser physics engines was a difficult task that required large amounts of complex code. This further slowed down the processing of the simulations.

The document entitled "Comparison of Physics Frameworks for WebGL-Based Game Engine" in the name of Resa et al. (2014) discloses the integration of several physics engines into a browser-based game engine. See https://www.epj-conferences.org/articles/epjconf/abs/2014/05/epjconf icas2013 00035/epiconf icas201 3 00035.html.

The documents entitled **"Intro to JavaScript 3D Physics using Ammo.js and Three.js" and "Moving Objects In JavaScript 3D Physics using Ammo.js and Three.js"** authored by a user with the moniker "Blue Magnificent" (2019) are tutorials, in two parts, about the browser-based simulation of 3D physics with the rendering engine "three.js" and the physics engine "ammo.js". See https://medium.com/@bluemagnificent/ intro-to-javascript-3d-physics-using-ammo-js-and-three-js-dd48df81f591 and https://medium.com/@bluemagnificent/moving-objects-in-javascript-3d-physics-using-ammo-js-and-three-ij-6e39eff6d9e5 respectively.

The document entitled "Paid work converting PhysX to WebAssembly #288" is a web forum discussion about a project of converting the physics engine PhysX into the browser-format WebAssembly, See: https://github.com/kripken/ammo.is/issues/288.

It is an object of the present invention to provide a computer implemented method, a computer program product, and an in-browser robotics simulator that overcome at least one of the above-identified problems. It is a further object of the present invention to provide a useful alternative choice for the consumer.

### Summary of Invention

According to the invention there is provided a computer implemented method of simulating a three-dimensional (3D) object for display in a browser on a client's device according to independent claim 1.

By having such a method, it will be possible to provide an in-browser simulation that can operate at approximately three times the frames per second (FPS) rate than previous offerings could achieve. This is due in part to the simulation API linking the physics engine and the rendering engine that will reduce the simulation code by up to in the region of 80%. In other words, the code will be of the order of 20% the size of the former code. This places less of a computational burden on the client device and it is possible to run at a higher FPS rate. In addition, due to the fact that the simulation runs client side and in browser, it is scalable and more cost effective to provide than previous offerings. By using a multi-threading technique, this can help to provide a smoother simulation for the user with more effective use of available resources. The number of available threads will depend on the user machine. By providing a plurality of versions, the version with the number of threads most suited to the machine it is running on can be determined and that version used in the simulation.

In one embodiment of the invention there is provided a computer implemented method in which the step of importing the physics library to the client's device comprises importing a subset of the available physics libraries to the client's device. In this way, the memory requirement on the client device will be reduced as well as the bandwidth required to transmit the physics libraries.

In one embodiment of the invention there is provided a computer implemented method in which the method comprises the step of determining which of the physics libraries is required for simulation of the 3D object and importing only those physics libraries required for the simulation of that 3D object. This is seen as a simple yet effective way of reducing the memory and bandwidth requirements.

In one embodiment of the invention there is provided a computer implemented method in which the method comprises storing the 3D object and the physics libraries on a content provider's web server. This is seen as a useful implementation as the content provider, the operator of the web server, can then deliver the content from their own web server in a more efficient manner. The content provider can also determine who has access to the content and when.

In one embodiment of the invention there is provided a computer implemented method in which the method comprises the step of storing the simulation application programming interface (API) and the simulation computer program code in a content delivery network (CDN). In this way, it will be possible to modify and update the API and simulation computer program code without recourse to the end users. Furthermore, this will also make it easier for the operator of the web server as they do not have to update existing files on the web server.

In one embodiment of the invention there is provided a computer implemented method comprising the step of running the physics engine in a web worker. This is seen as a useful implementation of the invention as the physics engine can be operating in the background and will be unimpeded by other operations on the web page.

In one embodiment of the invention there is provided a computer implemented method comprising the step of exporting the simulation as a shareable web link. This is seen as a simple way of sharing the simulation.

In one embodiment of the invention there is provided a in-browser robotics 3D object simulator according to independent claim 8.

By having such a simulator, it will be possible to provide an in-browser simulation that can operate at approximately three times the frames per second (FPS) rate than previous offerings could achieve. This is due in part to the simulation API linking the physics engine and the rendering engine that will reduce the simulation code to of the order of 20% the size of the former code. This places less of a computational burden on the client device and it is possible to run at a higher FPS rate. In addition, due to the fact that the simulation can run client side and in browser, it is scalable and more cost effective to provide than previous offerings. By using a multi-threading technique, this can help to provide a smoother simulation for the user with more effective use of available resources. The number of available threads will depend on the user machine. By providing a plurality of versions, the version with the number of threads most suited to the machine it is running on can be determined and that version used in the simulation.

In one embodiment of the invention there is provided an in-browser robotics 3D object simulator in which the physics engine is a port of a C++ physics engine. This is seen as a particularly useful implementation of the present invention as a modern, more powerful physics engine can be used to good effect. This will enhance the functionality of the offering.

In one embodiment of the invention there is provided an in-browser robotics 3D object simulator in which the physics engine is an emscripten port of a C++ physics engine. The emscripten port of the C++ engine will be particularly useful as it will allow the direct use of the physics engine in the web browser.

In one embodiment of the invention there is provided an in-browser robotics 3D object simulator in which the physics engine is PhysX. The PhysX physics engine, for example the PhysX 4.1 produced by Nvidia Corporation of Santa Clara, California, United States of America, is seen as a particularly suitable physics engine to use in the present invention that will allow for a richer, more immersive experience for the user.

In one embodiment of the invention there is provided an in-browser robotics 3D object simulator in which the rendering engine comprises a web graphics library (WebGL).

In one embodiment of the invention there is provided an in-browser robotics 3D object simulator in which the rendering engine comprises Three.js. The combination of PhysX and Three.js is seen as particularly preferred and leads to up to three times more FPS than other solutions.

In one embodiment of the invention there is provided an in-browser robotics 3D object simulator in which the physics engine is configured to operate in a web worker. This is seen as a useful implementation of the invention as the physics engine can be operating in the background and will be unimpeded by other operations on the web page. The use of a web worker will increase code efficiency. The web worker will make it possible to run a script operation in a background thread separate from the main execution thread of a web application. The advantage of this is that intensive processing may be performed in the background in a separate thread, allowing the main thread to run unimpeded.

In one embodiment of the invention there is provided an in-browser robotics 3D object simulator in which there is provided an accessible memory and a plurality of 3D objects stored in the accessible memory.

In one embodiment of the invention there is provided a computer program product having program instructions loaded thereon that when executed on a computer, cause the computer to carry out one or more of the method steps according to independent claim 16.

By having such a computer program product, it will be possible to provide an in-browser simulation that can operate at approximately three times the frames per second (FPS) rate than previous offerings could achieve. This is due in part to the simulation API linking the physics engine and the rendering engine that will reduce the simulation code to of the order of 20% the size of the former code. This places less of a computational burden on the client device and it is possible to run at a higher FPS rate. In addition, due to the fact that the simulation can run client side and in browser, it is scalable and more cost effective to provide than previous offerings. By using a multi-threading technique, this can help to provide a smoother simulation for the user with more effective use of available resources. The number of available threads will depend on the user machine. By providing a plurality of versions, the version with the number of threads most suited to the machine it is running on can be determined and that version used in the simulation.

In one embodiment of the invention there is provided a computer program product comprising program instructions loaded thereon that when executed on a computer, cause the computer to carry out one or more of the preparatory method steps of:
generating a 3D object and storing the 3D object in memory;
storing a plurality of physics libraries in memory; and
storing a simulation application programming interface (API) linking a physics engine and a rendering engine, and a simulation computer program code, in memory.

### Brief Description of the Drawings:

The invention will now be more clearly understood from the following description of some embodiments thereof given by way of example only with reference to the accompanying drawings, in which:-
Figure 1 is a diagrammatic representation of a system in which the method according to the invention may be performed;
Figure 2 is a perspective view of a typical simulation that may be performed by the computer implemented method according to the invention; and
Figure 3 is a schema of the simulator and its functional components.

### Detailed Description of the Drawings:

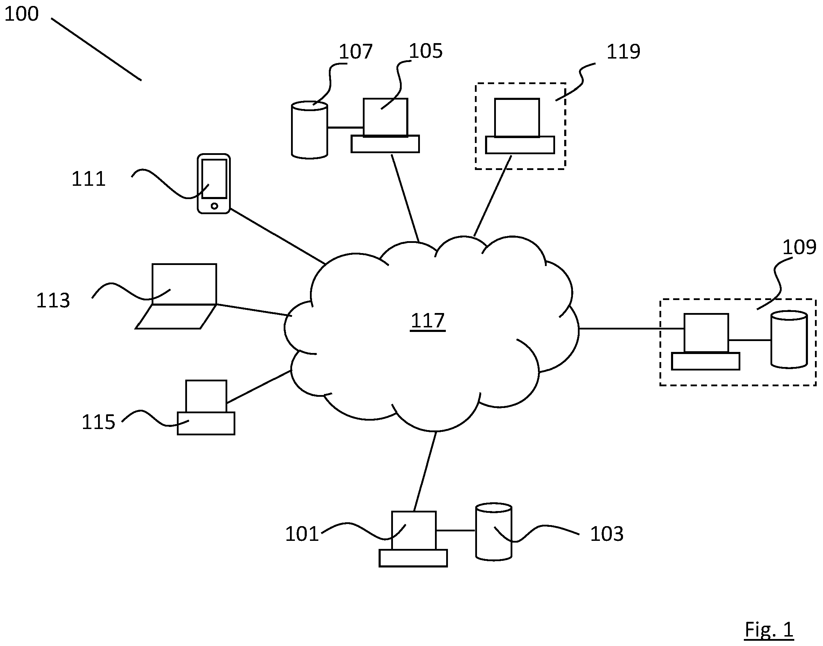

Referring to Figure 1, there is shown a system in which the method according to the invention may be implemented, indicated generally by the reference numeral 100. The system comprises an operator computing device 101 with associated memory 103, and a client-side device 105 with associated memory 107. There is further shown a remote computing device 109, forming part of a content distribution network (CDN) of the operator, a plurality of third-party computing devices including a smart phone 111, a laptop computer 113 and a PC 115, all of which can communicate with each other through communications network 117. Finally, there is provided a web server 119 for hosting content for a content provider, the content being accessible to the client device.

In use, the method comprises the initial steps of the operator generating a 3D object and storing the 3D object in memory 103. Furthermore, the operator stores a plurality of physics libraries in memory 103 along with a simulation application programming interface (API) linking a physics engine and a rendering engine, and a simulation computer program code. The simulation API and simulation computer program code may be stored in the CDN 109, whereas the 3D object and physics libraries may be stored on web server 119.

The simulation API is the code library, portions of reusable code that can be run using the API. The simulation computer program code is the code that is written to create a particular simulation of a 3D object. The simulation computer program code makes use of the simulation API library and will contain functions that can be found in the API library. Therefore, it will be necessary to load the API in order to run the simulation code. As indicated above, the API reduces the amount of code required. By this, what is meant is that the amount of code that is required to be written by the developer, i.e. the simulation computer program code. Strictly speaking, it is the features of the code library that allow for the code reduction as the API is the point of contact used for interaction between two running codes. The code library is written using best practices in that it is as efficient as possible.

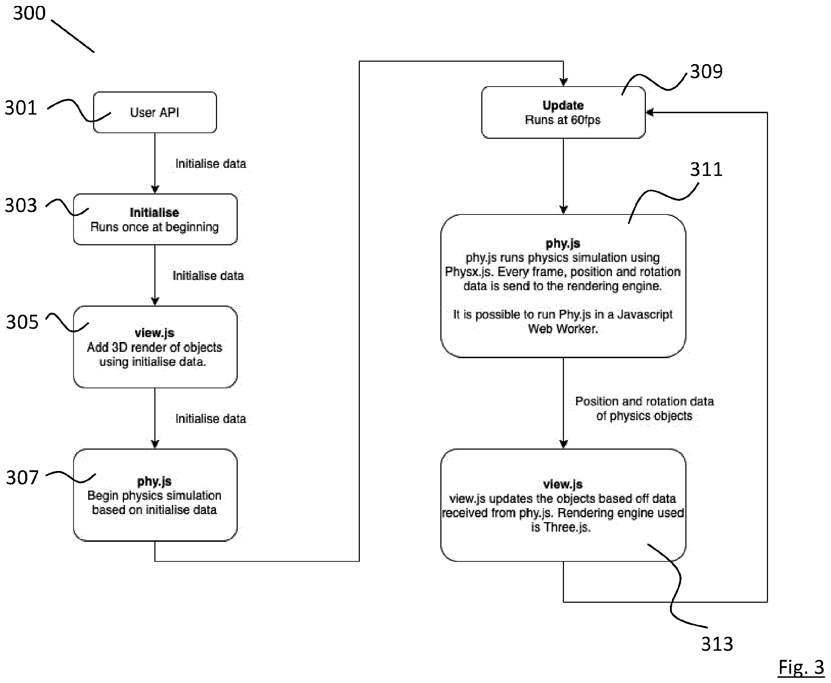

The client issues a web page load request using a browser (not shown) on the client's device 105. The method then comprises the steps of loading the simulation application programming interface (API) and the simulation computer program code onto the client's device 105 from the memory 103, (or from the CDN 109), importing the 3D object and at least one of the physics libraries to the client's device 105 from the web server 119, and simulating the 3D object using the simulation API, the rendering engine and the physics engine having access to the imported physics library. The 3D object is rendered in the client's browser, and, for each subsequent frame, the rendered 3D object is updated by using the physics engine to generate position and rotation data for the 3D object, that position and rotation data is sent to the rendering engine, and the rendering engine updates the rendered 3D object based on the position and rotation data received from the physics engine before displaying the updated rendered 3D object (as will be described in more detail below with respect to Figure 3).

Instead of client device 105, the client may use any of the client devices 111, 113, 115 shown, or indeed another client device capable of accessing the web server and displaying a web page. For example, a smartphone, an internet enabled television, a tablet, a phablet, a smart watch or the like could also be used to view the simulation.

Once the operator has completed the simulation of the content provider's robot, the operator provides the content provider with API documentation that will allow the content provider to easily control their simulation with Javascript (Registered Trade Mark ^{®}) commands. The following steps are then taken in order to integrate the simulation into the content provider's web page.

In step 1, the operator provides the content provider with a folder of files containing any 3D assets and the physics library files. ( Note : Any files that contain operator source code may be obfuscated using the tool https://obfuscator.io/.) In step 2, the content provider places these files in a folder on their web server 119. In step 3, the operator will host a CDN (only part of which, computing device 109, is shown, that contains the simulation API as well as the simulation code. This must be loaded onto the client device in order to run the simulation. This allows the operator to easily make updates to the code. In step 4, the content provider will integrate the simulation into their web page with code similar to the following code segment 1, shown below:

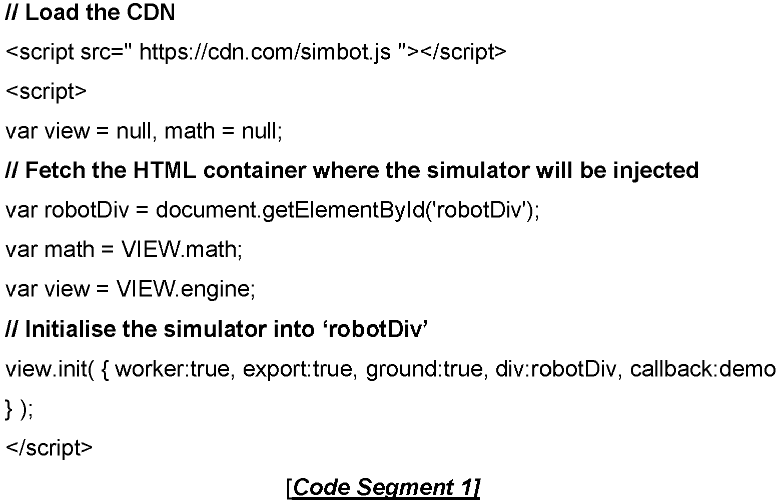

**The content** provider is thereafter ready to begin simulations through their web server to their customers (operating a client device).

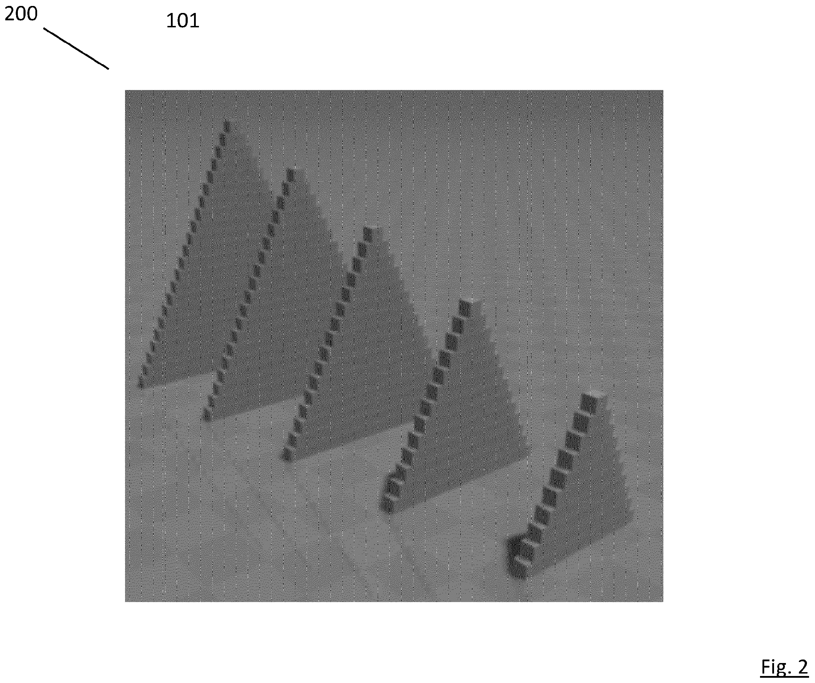

From a technical perspective, the method according to the present invention enables robotics simulations that were not previously possible to run in a native web browser. This is due in part to the port into Javascript ^{®} of Nvidia's ^{®} PhysX ^{®} 4.1 physics library. Until now, the most powerful in-browser engine has been Ammo.js which, as of March 2020, is a Javascript port of a 2013 physics engine. The use of PhysX 4.1 allows for new simulation possibilities, such as tank physics, 4WD vehicle physics, joint articulation physics (for simulating robotics such as Robot Arms), wheel slip physics and more. The Javascript port of PhysX also offers significant improvements in friction and performance with high numbers of simulated objects. Previously, development with in-browser physics engines was a difficult task that required large amounts of complex code. For example, a simple demo displaying a number of pyramids (as shown below in Figure 2, indicated generally by the reference numeral 200) previously required 232 lines of code but using the API according to the present invention, now only requires 43 lines of code, a reduction of over 80%.

In order to port PhysX, in one embodiment Emscripten was used. Emscripten (www.emscripten.org) is a source-to-source compiler used to compile C and C++ code into JavaScript.

The method and in particular the API component of the present invention makes it possible to add simulated bodies to a 3D scene with minimal amounts of code required. In order to add a simulated entity, whether that is a simple cube or a 4WD vehicle, it often only requires a single line of code which contains the configuration options for the simulated entity. For example, to add a cube to the simulation using the API according to the present invention, the following code segment 2 would be required:
view.add({ pos:[-10, 2.5, 0], size:[1,5,1], rot:[0,35,0] }) ***[Code Segment 2]***

In order to add a cube without the API according to the present invention, the code would look something like code segment 3 below:

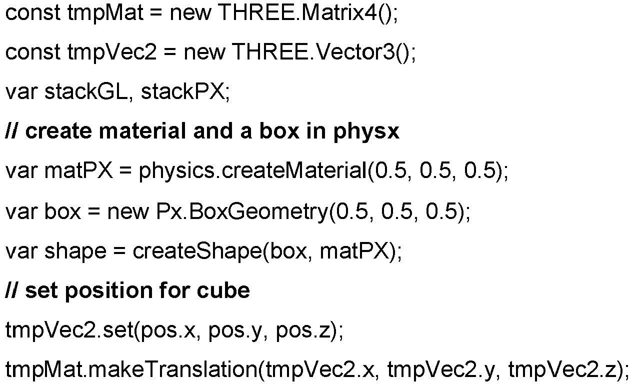

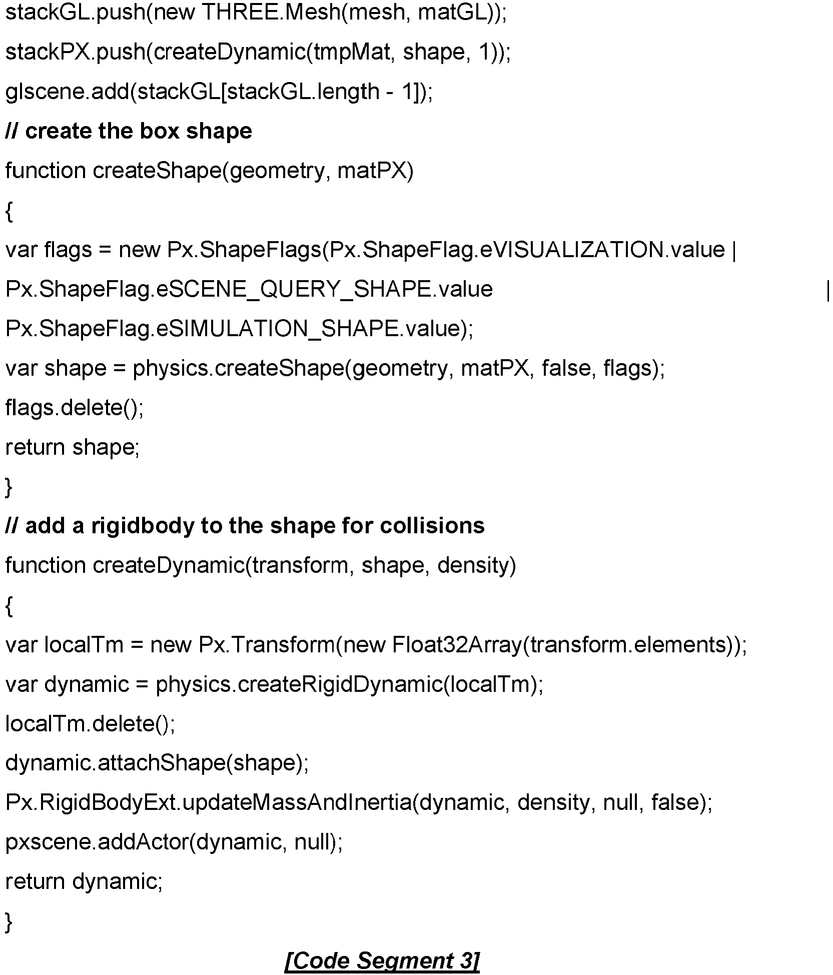

It can be seen therefore that the computation overhead and time to process the code will be significantly reduced. Another advantageous aspect of the API forming part of the present invention is that the API allows for automatic linking between the rendering and physics engine and provides simple API commands to do so. An example to add a 3D model with physics collisions using the API is illustrated in Code Segment 4 below:

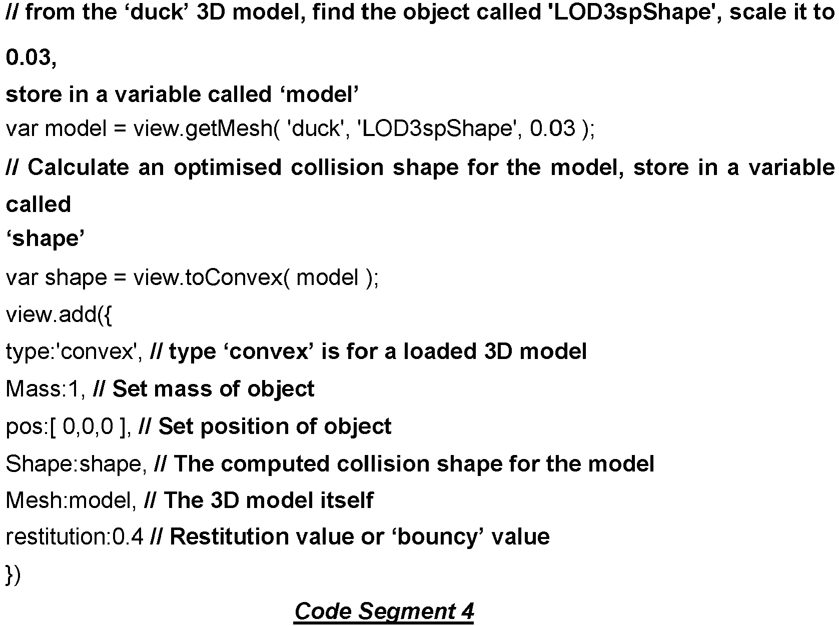

In addition to the foregoing, the present invention also runs multithreaded physics in a web browser which helps with performance when simulating a large number of objects at once. The simulator runs physics in a Javascript web worker by default, and there is no extra configuration required for convenience. In the present implementation of the invention, phy.js is being run in the web worker. Using the following code content from the code library:
worker = new Worker( isExport ? './build/phy.min.js' : './build/phy.js' ) ; a worker will be run using phy.min.js if the isExport Boolean is true, otherwise it will run phy.js in the Worker. It is possible to enable physics multithreading using the port of PhysX according to the invention. Multithreading is only supported on Google Chrome browser at the moment however it is envisaged that extension to other browsers will be readily understood to the skilled addressee. The only change required to allow for multi-threading is the following line of code, shown as code segment 5 below, illustrating the use of three threads, along with the alternative line of code for no multithreading:

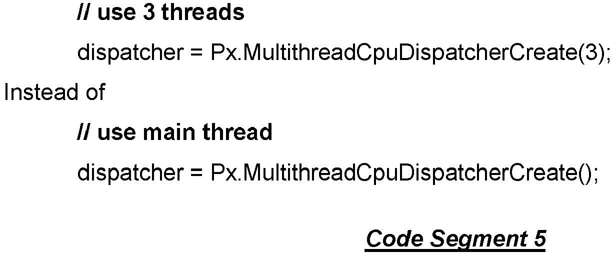

These are functions that are built into the PhysX library. While this can increase performance on certain devices, there are some limitations of multithreading using the port of PhysX developed according to the present invention. First of all, the program memory cannot dynamically "grow", so this means that the memory requirements are hardcoded at compilation time (For example: 128MB). This is an Emscripten specific limitation. In order to circumvent the problem, it is possible to do a malloc/new (dynamic memory allocation), but it cannot exceed the hardcoded limit. This is troublesome because the operator must have a good understanding of the scene memory requirements, or allocate a high memory limit from the beginning (which can be a waste of resources). Secondly, the number of threads must also be hardcoded at compilation time (For example: 2 threads, etc.). This is because of PhysX itself and not Emscripten which is able to allocate threads dynamically. But this is problematic too, as the number of available threads depend on the user machine. For this problem, the following workaround may be used: as detecting the number of threads is possible from Javascript, if a version for each typical thread configuration (1,2,4,8) is complied, there will be the opportunity to start the version that would best suit the host platform. In this way, the resources are used more effectively and the code will be processed more efficiently.

Referring now to Figure 3, there is shown a schema of the simulator and its functional components, indicated generally by the reference numeral 300. The client uses User API in step 301 to begin the process. This includes step 303, an initialisation step, which sets the parameters for the simulation and runs once at the beginning. Thereafter, in step 305, the component view.js adds the 3D render of objects using the initialisation data and in step 307, the phy.js component begins the physics simulation based on the initialisation data. The simulation is updated in step 309. The updates run at 60 frames per second which will be practically seamless to a viewer. Once updated, simulation proceeds to step 311 in which the phy.js component runs the physics simulation using Physx.js. For each frame, the position and rotation data is sent to the rendering engine. It is possible to run the Phy.js in a Javascript web worker if desired. In step 313, the view.js will update the objects based on the data received from phy.js in the previous step. The rendering engine used is Three.js. Three.js is a cross-browser JavaScript Library and API used to create and display 3D graphics in a web browser. After the frame is rendered, the method reverts back to step 309, the update and then cycles through steps 311 and 313 for the simulation. If desired, a break may be introduced into the method so that it will only cycle through the steps 309, 311, 313 a predetermined number of times before completing the simulation.

It will be understood from the foregoing that there are numerous uses and benefits for the present invention. For example, it is envisaged that the 3D object may be a piece of equipment, the web server may be operated by a manufacturer/supplier of assembly line equipment and the client device may be operated by a potential customer. The potential customer can simulate the operation of the equipment to determine whether or not it will function as required and what clearances etc are required. Alternatively, the content provider may be a provider of online games and the client device may be operated by a gamer, operating a robot or other device in a challenge against the clock or other users. Alternatively still, the web server could be operated by a company or organisation for their design team (internal, external or both internal and external) and the design team may be able to access the simulation, evaluate the simulation and see if and how it could be improved prior to going into production. Similarly, the 3D object could be a vehicle such as an airplane, helicopter or spacecraft, or several vehicles simulated together such as cars, motorcycles, trucks, boats or combinations thereof, and the simulation could be used by a crash investigation team determining likely cause of failure and/or likely sequence of events in a crash or the like.

It will be further understood that various parts of the present invention are performed in hardware and other parts of the invention may be performed either in hardware and/or software. It will be understood that the method steps and various components of the present invention will be performed largely in software and therefore the present invention extends also to computer programs, on or in a carrier, comprising program instructions for causing a computer or a processor to carry out steps of the method or provide functional components for carrying out those steps. The computer program may be in source code format, object code format or a format intermediate source code and object code. The computer program may be stored on or in a carrier, in other words a computer program product, including any computer readable medium, including but not limited to a floppy disc, a CD, a DVD, a memory stick, a tape, a RAM, a ROM, a PROM, an EPROM or a hardware circuit. In certain circumstances, a transmissible carrier such as a carrier signal when transmitted either wirelessly and/or through wire and/or cable could carry the computer program in which cases the wire and/or cable constitute the carrier.

It will be further understood that the present invention may be performed on two, three or more devices with certain parts of the invention being performed by one device and other parts of the invention being performed by another device. The devices may be connected together over a communications network. The present invention and claims are intended to also cover those instances where the system and/or method is operated across two or more devices or pieces of apparatus located in one or more locations.

In this specification the terms "comprise, comprises, comprised and comprising" and the terms "include, included, includes and including" are all deemed interchangeable and should be afforded the widest possible interpretation.

The invention is not limited to the embodiments hereinbefore described but may be varied in both construction and detail within the scope of the appended claims.

## Claims

1. A computer implemented method of simulating a three-dimensional (3D) object for display in a browser on a client's device (105, 111, 113, 115), the method comprising the initial steps of:
generating a 3D object and storing the 3D object in memory (103);
storing a plurality of physics libraries in memory (103);
storing a simulation application programming interface (API) linking a physics engine and a rendering engine, and a simulation computer program code, in memory (109); and
on a web page load request issued through the browser on the client's device (105):
loading the simulation application programming interface (API) and the simulation computer program code onto the client's device (105);
importing the 3D object and at least one of the physics libraries to the client's device (105);
simulating the 3D object using the simulation API, the rendering engine, and the physics engine having access to the imported physics library;
rendering the 3D object in the client's browser, and, for each subsequent frame:
updating (309, 311) the rendered 3D object by using the physics engine to generate position and rotation data for the 3D object and sending that position and rotation data to the rendering engine;
the rendering engine updating (313) the rendered 3D object based on the position and rotation data received from the physics engine and displaying the updated rendered 3D object;
**characterised in that** the method further comprises the steps of:
simulating the 3D object using a multi-threading technique in the physics engine; and
compiling a version for each of a plurality of thread configurations, and on start of simulation, determining the version of thread configuration that is most suited to the client's device and running that version on the client's device.

2. A computer implemented method as claimed in claim 1 in which the step of importing the physics library to the client's device (105) comprises importing a subset of the available physics libraries to the client's device.

3. A computer implemented method as claimed in claim 2 in which the method comprises the step of determining which of the physics libraries is required for simulation of the 3D object and importing only those physics libraries required for the simulation of that 3D object.

4. A computer implemented method as claimed in any preceding claim in which the method comprises storing the 3D object and the physics libraries on a content provider's web server (119).

5. A computer implemented method as claimed in any preceding claim in which the method comprises the step of storing the simulation application programming interface (API) and the simulation computer program code in a content delivery network (CDN) (109).

6. A computer implemented method as claimed in any preceding claim comprising the step of running the physics engine in a web worker.

7. A computer implemented method as claimed in any preceding claim comprising the step of exporting the simulation as a shareable web link.

8. An in-browser robotics 3D object simulator (300) comprising:
a rendering engine configured for operation in-browser;
a physics engine configured for operation in-browser; and
an application programming interface (API) mapping (301, 303, 305, 307) the functions of the physics engine to the rendering engine;
**characterised in that** the physics engine is configured to simulate the 3D object using a multi-threading technique; and
the in-browser robotics 3D object simulator is configured to compile a version for each of a plurality of thread configurations, and on start of simulation, determine the version of thread configuration that is most suited to a client's device and running that version on the client's device.

9. An in-browser robotics 3D object simulator (300) as claimed in claim 8 in which the physics engine is a port of a C++ physics engine.

10. An in-browser robotics 3D object simulator (300) as claimed in claim 8 or 9 in which the physics engine is an emscripten port of a C++ physics engine.

11. An in-browser robotics 3D object simulator (300) as claimed in any one of claims 9 or 10 in which the physics engine is PhysX.

12. An in-browser robotics 3D object simulator (300) as claimed in any one of claims 8 to 11 in which the rendering engine comprises a web graphics library (WebGL).

13. An in-browser robotics 3D object simulator (300) as claimed in any one of claims 8 to 12 in which the rendering engine comprises Three.js.

14. An in-browser robotics 3D object simulator (300) as claimed in any one of claims 8 to 13 in which the physics engine is configured to operate in a web worker.

15. An in-browser robotics 3D object simulator (300) as claimed in any one of claims 8 to 14 in which there is provided an accessible memory and a plurality of 3D objects stored in the accessible memory.

16. A computer program product (300) having program instructions loaded thereon that when executed on a computer (105, 111, 113, 115), cause the computer to carry out one or more of the method steps of:
on a web page load request issued through a browser on a client's device (105):
loading (301) a simulation application programming interface (API) and a simulation computer program code onto the client's device;
importing (303) a 3D object and at least one of a plurality of physics libraries to the client's device;
simulating (305) the 3D object using the simulation API, a rendering engine, and a physics engine having access to the imported physics library;
rendering (307) the 3D object in the client's browser, and, for each subsequent frame:
updating (309) the rendered 3D object by using the physics engine to generate (311) position and rotation data for the 3D object and sending that position and rotation data to the rendering engine;
the rendering engine updating (313) the rendered 3D object based on the position and rotation data received from the physics engine and displaying the updated rendered 3D object;
**characterised in that** the computer program product has program instructions to cause the computer (105) to carry out the method steps of:
simulating the 3D object using a multi-threading technique in the physics engine; and
compiling a version for each of a plurality of thread configurations, and on start of simulation, determining the version of thread configuration that is most suited to the client's device and running that version on the client's device.

17. A computer program product (300) as claimed in claim 16 comprising program instructions loaded thereon that when executed on a computer (105, 1111, 113, 115), cause the computer to carry out one or more of the preparatory method steps of:
generating a 3D object and storing the 3D object in memory (103);
storing a plurality of physics libraries in memory (103); and
storing a simulation application programming interface (API) linking a physics engine and a rendering engine, and a simulation computer program code, in memory (109).

## Patentansprüche

1. Computerimplementiertes Verfahren zum Simulieren eines dreidimensionalen (3D) Objekts zum Anzeigen in einem Browser auf einem Klientengerät (105, 111, 113, 115), wobei das Verfahren die folgenden einleitenden Schritte umfasst:
Erzeugen eines 3D-Objekts und Speichern des 3D-Objekts in einem Arbeitsspeicher (103);
Speichern einer Mehrzahl von Physikbibliotheken in einem Arbeitsspeicher (103);
Speichern einer Simulations-Anwendungsprogrammierschnittstelle (API), die ein Physikmodul und ein Renderingmodul verknüpft, und eines Simulations-Computerprogrammcodes in einem Arbeitsspeicher (109); und
auf eine über den Browser auf dem Klientengerät (105) ausgestellte Ladeanforderung für eine Webseite hin:
Laden der Simulations-Anwendungsprogrammierschnittstelle (API) und des Simulations-Computerprogrammcodes auf das Klientengerät (105);
Importieren des 3D-Objekts und mindestens einer der Physikbibliotheken auf das Klientengerät (105);
Simulieren des 3D-Objekts unter Verwendung des Simulations-API, des Rendering-Moduls und des Physikmoduls, welches Zugriff auf die importierte Physikbibliothek hat;
Rendern des 3D-Objekts im Browser des Klienten und, für jedes nachfolgende Frame:
Aktualisieren (309, 311) des gerenderten 3D-Objekts durch Verwenden des Physikmoduls zum Erzeugen von Positions- und
Rotationsdaten für das 3D-Objekt und Senden dieser Positions- und Rotationsdaten an das Renderingmodul;
Aktualisieren (313), durch das Renderingmodul, des gerenderten 3D-Objekts auf der Basis der vom Physikmodul her empfangenen Positions- und Rotationsdaten und Anzeigen des aktualisierten gerenderten 3D-Objekts;
**dadurch gekennzeichnet, dass** das Verfahren ferner die folgenden Schritte umfasst:
Simulieren des 3D-Objekts unter Verwendung einer Multithreading-Technik im Physikmodul; und
Kompilieren einer Version für jede aus einer Mehrzahl von Threadkonfigurationen und auf den Start der Simulation hin Bestimmen der Version der Threadkonfiguration, die für das Klientengerät am besten geeignet ist, und Betreiben jener Version auf dem Klientengerät.

2. Computerimplementiertes Verfahren nach Anspruch 1, in welchem der Schritt des Importierens der Physikbibliothek auf das Klientengerät (105) Importieren eines Teilsatzes der verfügbaren Physikbibliotheken auf das Klientengerät umfasst.

3. Computerimplementiertes Verfahren nach Anspruch 2, in welchem das Verfahren den Schritt des Bestimmens, welche der Physikbibliotheken zur Simulation des 3D-Objekts erforderlich ist, und Importieren nur jener Physikbibliotheken, welche zur Simulation jenes 3D-Objekts erforderlich sind, umfasst.

4. Computerimplementiertes Verfahren nach einem der vorangehenden Ansprüche, in welchem das Verfahren Speichern des 3D-Objekts und der Physikbibliotheken auf einem Webserver (119) eines Inhaltsanbieters umfasst.

5. Computerimplementiertes Verfahren nach einem der vorangehenden Ansprüche, in welchem das Verfahren den Schritt des Speicherns der Simulations-Anwendungsprogrammierschnittstelle (API) und des Simulations-Computerprogrammcodes in einem Content Delivery Network (CDN) (109) umfasst.

6. Computerimplementiertes Verfahren nach einem der vorangehenden Ansprüche, umfassend den Schritt des Betreibens des Physikmoduls in einem Web Worker.

7. Computerimplementiertes Verfahren nach einem der vorangehenden Ansprüche, umfassend den Schritt des Exportierens der Simulation als ein teilbarer Weblink.

8. Browserintegrierter Robotik-3D-Objekt-Simulator (300), umfassend:
ein Renderingmodul konfiguriert zu browserintegriertem Betrieb;
ein Physikmodul konfiguriert zu browserintegriertem Betrieb; und ein Anwendungsprogrammierschnittstellen(-API)-Mapping (301, 303, 305, 307) der Funktionen des Physikmoduls auf das Renderingmodul;
**dadurch gekennzeichnet, dass** das Physikmodul zum Simulieren des 3D-Objekts unter Verwendung einer Multithreading-Technik konfiguriert ist; und
dass der browserintegrierte Robotik-3D-Objekt-Simulator zum Kompilieren einer Version für jede aus einer Mehrzahl von Threadkonfigurationen und auf den Start der Simulation hin zum Bestimmen der Version der Threadkonfiguration, die für das Klientengerät am besten geeignet ist, und zum Betreiben jener Version auf dem Klientengerät konfiguriert ist.

9. Browserintegrierter Robotik-3D-Objekt-Simulator (300) nach Anspruch 8, in welchem das Physikmodul ein Port eines C++-Physikmoduls ist.

10. Browserintegrierter Robotik-3D-Objekt-Simulator (300) nach Anspruch 8 oder 9, in welchem das Physikmodul ein Emscripten-Port eines C++-Physikmoduls ist.

11. Browserintegrierter Robotik-3D-Objekt-Simulator (300) nach einem der Ansprüche 9 oder 10, in welchem das Physikmodul PhysX ist.

12. Browserintegrierter Robotik-3D-Objekt-Simulator (300) nach einem der Ansprüche 8 bis 11, in welchem das Renderingmodul eine Webgrafikbibliothek (WebGL) umfasst.

13. Browserintegrierter Robotik-3D-Objekt-Simulator (300) nach einem der Ansprüche 8 bis 12, in welchem das Renderingmodul Three.js umfasst.

14. Browserintegrierter Robotik-3D-Objekt-Simulator (300) nach einem der Ansprüche 8 bis 13, in welchem das Physikmodul zum Betrieb in einem Web Worker konfiguriert ist.

15. Browserintegrierter Robotik-3D-Objekt-Simulator (300) nach einem der Ansprüche 8 bis 14, in welchem ein zugreifbarer Arbeitsspeicher und eine Mehrzahl von im zugreifbaren Arbeitsspeicher gespeicherten 3D-Objekten bereitgestellt sind.

16. Computerprogrammprodukt (300) mit darin geladenen Programminstruktionen, die bei Ausführung auf einem Computer (105, 111, 113, 115) den Computer veranlassen, einen oder mehrere der folgenden Verfahrensschritte auszuführen:
auf eine über einen Browser auf einem Klientengerät (105) ausgestellte Ladeanforderung für eine Webseite hin:
Laden (301) einer Simulations-Anwendungsprogrammierschnittstelle (API) und eines Simulations-Computerprogrammcodes auf das Klientengerät;
Importieren (303) eines 3D-Objekts und mindestens einer aus einer Mehrzahl von Physikbibliotheken auf das Klientengerät;
Simulieren (305) des 3D-Objekts unter Verwendung des Simulations-API, eines Rendering-Moduls und eines Physikmoduls, welches Zugriff auf die importierte Physikbibliothek hat;
Rendern (307) des 3D-Objekts im Browser des Klienten und, für jedes nachfolgende Frame:
Aktualisieren (309) des gerenderten 3D-Objekts durch Verwenden des Physikmoduls zum Erzeugen (311) von Positions- und Rotationsdaten für das 3D-Objekt und Senden dieser Positions- und Rotationsdaten an das Renderingmodul;
Aktualisieren (313), durch das Renderingmodul, des gerenderten 3D-Objekts auf der Basis der vom Physikmodul her empfangenen Positions- und Rotationsdaten und Anzeigen des aktualisierten gerenderten 3D-Objekts;
**dadurch gekennzeichnet, dass** das Computerprogrammprodukt Programminstruktionen aufweist, die den Computer (105) dazu veranlassen, die folgenden Verfahrensschritte auszuführen:
Simulieren des 3D-Objekts unter Verwendung einer Multithreading-Technik im Physikmodul; und
Kompilieren einer Version für jede aus einer Mehrzahl von Threadkonfigurationen und auf den Start der Simulation hin Bestimmen der Version der Threadkonfiguration, die für das Klientengerät am besten geeignet ist, und Betreiben jener Version auf dem Klientengerät.

17. Computerprogrammprodukt (300) nach Anspruch 16, umfassend darin geladene Programminstruktionen, die bei Ausführung auf einem Computer (105, 1111, 113, 115) den Computer veranlassen, einen oder mehrere der folgenden vorbereitenden Verfahrensschritte auszuführen:
Erzeugen eines 3D-Objekts und Speichern des 3D-Objekts in einem Arbeitsspeicher (103);
Speichern einer Mehrzahl von Physikbibliotheken in einem Arbeitsspeicher (103); und
Speichern einer Simulations-Anwendungsprogrammierschnittstelle (API), die ein Physikmodul und ein Renderingmodul verknüpft, und eines Simulations-Computerprogrammcodes in einem Arbeitsspeicher (109).

## Revendications

1. Procédé mis en œuvre par ordinateur de simulation d'un objet tridimensionnel (3D) à afficher dans un navigateur sur un dispositif (105, 111, 113, 115) d'un client, le procédé comprenant les étapes initiales consistant à :
générer un objet 3D et stocker l'objet 3D en mémoire (103) ;
stocker une pluralité de bibliothèques physiques en mémoire (103) ;
stocker en mémoire (109) une interface de programmation d'application (API) de simulation reliant un moteur physique et un moteur de rendu, ainsi qu'un code de programme informatique de simulation ; et
lors d'une requête de chargement de page Web émise par l'intermédiaire du navigateur sur le dispositif (105) du client :
charger l'interface de programmation d'application (API) de simulation et le code de programme informatique de simulation sur le dispositif (105) du client ;
importer l'objet 3D et au moins une des bibliothèques physiques sur le dispositif (105) du client ;
simuler l'objet 3D au moyen de l'API de simulation, du moteur de rendu et du moteur physique ayant accès à la bibliothèque physique importée ;
rendre l'objet 3D dans le navigateur du client, puis, pour chaque trame suivante :
mettre à jour (309, 311) l'objet 3D rendu au moyen du moteur physique pour générer des données de position et de rotation pour l'objet 3D, puis envoyer ces données de position et de rotation au moteur de rendu ;
mettre à jour (313), par le moteur de rendu, l'objet 3D rendu sur la base des données de position et de rotation reçues en provenance du moteur physique, et afficher l'objet 3D rendu mis à jour ;
le procédé étant **caractérisé en ce qu'**il comprend en outre les étapes consistant à :
simuler l'objet 3D au moyen d'une technique de traitement multifil d'exécution dans le moteur physique ; et
compiler une version pour chaque configuration de fil parmi une pluralité de configurations de fils et, au démarrage de la simulation, déterminer la version de la configuration de fil qui convient le mieux au dispositif du client, et exécuter cette version sur le dispositif du client.

2. Procédé mis en œuvre par ordinateur selon la revendication 1, l'étape consistant à importer la bibliothèque physique sur le dispositif (105) du client comprenant l'importation d'un sous-ensemble des bibliothèques physiques disponibles sur le dispositif du client.

3. Procédé mis en œuvre par ordinateur selon la revendication 2, le procédé comprenant l'étape consistant à déterminer laquelle des bibliothèques physiques est nécessaire à la simulation de l'objet 3D et à importer uniquement les bibliothèques physiques nécessaires à la simulation de cet objet 3D.

4. Procédé mis en œuvre par ordinateur selon l'une quelconque des revendications précédentes, le procédé comprenant le stockage de l'objet 3D et des bibliothèques physiques sur un serveur web (119) d'un fournisseur de contenu.

5. Procédé mis en œuvre par ordinateur selon l'une quelconque des revendications précédentes, le procédé comprenant l'étape consistant à stocker l'interface de programmation d'application (API) de simulation et le code de programme informatique de simulation dans un réseau de distribution de contenu (CDN) (109).

6. Procédé mis en œuvre par ordinateur selon l'une quelconque des revendications précédentes, comprenant l'étape consistant à exécuter le moteur physique dans un Web Worker.

7. Procédé mis en œuvre par ordinateur selon l'une quelconque des revendications précédentes, comprenant l'étape consistant à exporter la simulation en tant que lien Web partageable.

8. Simulateur d'objet 3D robotique au sein d'un navigateur (300), comprenant :
un moteur de rendu configuré pour fonctionner au sein d'un navigateur ;
un moteur physique configuré pour fonctionner au sein d'un navigateur ; et
une interface de programmation d'application (API) mettant en correspondance (301, 303, 305, 307) les fonctions du moteur physique avec celles du moteur de rendu ;
le simulateur étant **caractérisé en ce que** le moteur physique est configuré pour simuler l'objet 3D au moyen d'une technique de traitement multifil d'exécution ; et
le simulateur d'objet 3D robotique au sein d'un navigateur étant configuré pour compiler une version pour chaque configuration de fil parmi une pluralité de configurations de fils et, au démarrage de la simulation, déterminer la version de la configuration de fil qui convient le mieux à un dispositif d'un client, et exécuter cette version sur le dispositif du client.

9. Simulateur d'objet 3D robotique au sein d'un navigateur (300) selon la revendication 8, le moteur physique étant un port d'un moteur physique C++.

10. Simulateur d'objet 3D robotique au sein d'un navigateur (300) selon la revendication 8 ou 9, le moteur physique étant un port emscripten d'un moteur physique C++.

11. Simulateur d'objet 3D robotique au sein d'un navigateur (300) selon l'une quelconque des revendications 9 et 10, le moteur physique étant PhysX.

12. Simulateur d'objet 3D robotique au sein d'un navigateur (300) selon l'une quelconque des revendications 8 à 11, le moteur de rendu comprenant une bibliothèque de graphiques Web (WebGL).

13. Simulateur d'objet 3D robotique au sein d'un navigateur (300) selon l'une quelconque des revendications 8 à 12, le moteur de rendu comprenant Three.js.

14. Simulateur d'objet 3D robotique au sein d'un navigateur (300) selon l'une quelconque des revendications 8 à 13, le moteur physique étant configuré pour fonctionner dans un Web Worker.

15. Simulateur d'objet 3D robotique au sein d'un navigateur (300) selon l'une quelconque des revendications 8 à 14, une mémoire accessible et une pluralité d'objets 3D stockés dans la mémoire accessible étant fournis.

16. Produit-programme informatique (300) sur lequel sont chargées des instructions de programme qui, lorsqu'elles sont exécutées sur un ordinateur (105, 111, 113, 115), amènent l'ordinateur à réaliser une ou plusieurs des étapes de procédé consistant à :
lors d'une requête de chargement de page Web émise par l'intermédiaire d'un navigateur sur un dispositif (105) d'un client :
charger (301) une interface de programmation d'application (API) de simulation et un code de programme informatique de simulation sur le dispositif du client ;
importer (303) sur le dispositif du client un objet 3D et au moins une bibliothèque physique parmi une pluralité de bibliothèques physiques ;
simuler (305) l'objet 3D au moyen de l'API de simulation, d'un moteur de rendu et d'un moteur physique ayant accès à la bibliothèque physique importée ;
rendre (307) l'objet 3D dans le navigateur du client, puis, pour chaque trame suivante :
mettre à jour (309) l'objet 3D rendu au moyen du moteur physique pour générer (311) des données de position et de rotation pour l'objet 3D, puis envoyer ces données de position et de rotation au moteur de rendu ;
mettre à jour (313), par le moteur de rendu, l'objet 3D rendu sur la base des données de position et de rotation reçues en provenance du moteur physique, et afficher l'objet 3D rendu mis à jour ;
le produit-programme informatique étant **caractérisé en ce qu'**il comporte des instructions pour amener l'ordinateur (105) à réaliser les étapes de procédé consistant à :
simuler l'objet 3D au moyen d'une technique de traitement multifil d'exécution dans le moteur physique ; et
compiler une version pour chaque configuration de fil parmi une pluralité de configurations de fils et, au démarrage de la simulation, déterminer la version de la configuration de fil qui convient le mieux au dispositif du client, et exécuter cette version sur le dispositif du client.

17. Produit-programme informatique (300) selon la revendication 16, sur lequel sont chargées des instructions de programme qui, lorsqu'elles sont exécutées sur un ordinateur (105, 1111, 113, 115), amènent l'ordinateur à réaliser une ou plusieurs des étapes de procédé préliminaires consistant à :
générer un objet 3D et stocker l'objet 3D en mémoire (103) ;
stocker une pluralité de bibliothèques physiques en mémoire (103) ; et
stocker en mémoire (109) une interface de programmation d'application (API) de simulation reliant un moteur physique et un moteur de rendu, ainsi qu'un code de programme informatique de simulation.
